# EUROPEAN PATENT APPLICATION

(11) **EP 4 744 952 A1**
(43) Date of publication of application: **20.05.2026**
(21) Application number: 23950952.4
(22) Date of filing: 19.12.2023
(51) Int. Cl.: B60L 58/16, B60L 58/12, B60L 7/18, B60L 15/20

(54) **SYSTEM AND METHOD FOR DETERMINING AND MANAGING BATTERY DEGRADATION**

(30) Priority: 29.08.2023 KR 20230114042; 10.11.2023 KR 20230155379
(71) Applicant: LG Energy Solution, Ltd., Seoul 07335 (KR)
(72) Inventor: KOO, Ja Hoon, Daejeon 34122 (KR)
(74) Representative: Plasseraud IP
(86) International application number: PCT/KR2023/021026
(87) International publication number: WO 2025/048077

(57) **Abstract**

According to some embodiments disclosed in this disclosure, a computing system may comprise an interface circuit; and at least one processor operatively coupled to the interface circuit, wherein the at least one processor may be configured to acquire battery data related to a battery of a vehicle, determine a regenerative braking level of the vehicle based on the battery data, adjust a driving strategy of the vehicle based on the regenerative braking level, and control driving of the vehicle based on the regenerative braking level and the driving strategy.

## Description

### TECHNICAL FIELD

### CROSS-REFERENCE TO RELATED APPLICATION

The present application claims priority to Korean Patent Application No. 10-2023-0155379, filed on November 10, 2023 and Korean Patent Application No. 10-2023-0114042, filed on August 29, 2023, the entire contents of which is incorporated herein for all purposes by this reference.

### TECHNICAL FIELD

This disclosure relates to systems and methods for determining battery degradation resulting from regenerative braking.

### BACKGROUND ART

As the demand for eco-friendly vehicles increases, electric vehicles (EVs) with batteries such as lithium-ion secondary batteries as an energy source are rapidly replacing existing internal combustion engine vehicles. Meanwhile, as artificial intelligence technology and various sensor technologies are advanced, research and development for improving the performance of hardware and software related to autonomous driving systems are also being actively conducted.

An autonomous driving system to support vehicle autonomous driving has been developed or provided in the form of autonomous driving platforms including various sensors and control units. Some electric vehicle manufacturers are mass-producing or developing autonomous driving electric vehicles based on autonomous driving platforms.

Regenerative braking may refer to a braking method in which a battery is charged using a power generation function of a motor when a vehicle having a battery as an energy source and a motor as a driving means brakes. Regenerative braking may be performed at different levels, and the braking force of the vehicle and the charging amount of the battery may vary according to the level of regenerative braking. The driving control device of the electric vehicle may determine an appropriate level of regenerative braking, and may control the driving of the electric vehicle accordingly. However, regenerative braking may inevitably cause degradation of the battery in that the battery is repeatedly charged and discharged. Thus, the battery is degraded more rapidly than if no regenerative braking is used. Such rapid degradation of the batteries results in the need to replace the batteries more frequently, causing more emissions and/or greenhouse gases being produced during the production of the batteries. Such emissions and/or greenhouse gases may adversely affect the environment, such as by leading to climate change.

### DISCLOSURE

### TECHNICAL PROBLEM

One object of embodiments disclosed herein is to provide a battery management system, a vehicle, a battery management method, and a computer program that can consider regenerative braking of a vehicle when predicting a degree of battery degradation and, in some instances, adjust the charging and/or discharging of the battery to reduce battery degradation. By predicting a degree of battery degradation based on regenerative braking levels and adjusting the charging and/or discharging of the battery to reduce battery degradation, the overall lifespan of the battery may be increased, thereby leading to reduced levels of emissions and/or greenhouse gases being produced during the production of the batteries. Furthermore, the technology described herein can be implemented in the automated vehicle platforms of many types of vehicles, leading to widespread improvements in energy efficiency.

One object of embodiments disclosed herein is to provide a computing system, a vehicle, a method for operating the computing system, and a computer program capable of determining a regenerative braking and/or driving strategy of a vehicle in consideration of the degradation of a battery.

The technical problems to be solved in the present disclosure are not limited to the above-mentioned technical problems, and any other technical problems not mentioned will be clearly understood from the following description by those skilled in the art.

### TECHNICAL SOLUTION

Aspects of the disclosure may include a computing system. The computing system may include at least one processor configured to: receive battery data related to a battery of a vehicle; determine a regenerative braking level of the vehicle based on the battery data; adjust a driving strategy of the vehicle based on the regenerative braking level; and control driving of the vehicle based on the driving strategy.

In some instances, the battery data includes a state of charge (SOC) level of the battery and the at least one processor is further configured to: determine the regenerative braking level based on a relationship inversely proportional to the SOC level.

In some examples, the at least one processor is further configured to: calculate a discharging amount of the SOC level based on driving of the vehicle and a charging amount of the SOC level based on regenerative braking of the vehicle, wherein the regenerative braking level is determined based on the discharging amount and the charging amount.

In some examples, the at least one processor is further configured to: calculate a predicted discharging amount and a predicted charging amount of the SOC level after a predetermined time has elapsed, wherein calculating the predicted discharging amount and the predicted charging amount is based on the discharging amount and the charging amount; and determine a next level of the regenerative braking level based on the predicted discharging amount and the predicted charging amount.

In some instances, adjusting the driving strategy of the vehicle based on the regenerative braking level includes adjusting one or more of a driving speed, driving route, driving responsiveness, or headway distance setting of the vehicle.

In some examples, wherein adjusting the driving strategy of the vehicle based on the regenerative braking level includes increasing the driving speed of the vehicle and/or decreasing the headway distance setting when the regenerative braking level increases.

In some examples, adjusting the driving strategy of the vehicle based on the regenerative braking level includes increasing the driving responsiveness and/or setting the driving route to a route requiring more braking by the vehicle when the regenerative braking level increases.

In some examples, adjusting the driving strategy of the vehicle based on the regenerative braking level includes decreasing the driving speed of the vehicle and/or increasing the headway distance setting when the regenerative braking level decreases.

In some examples, adjusting the driving strategy of the vehicle based on the regenerative braking level includes decreasing the driving responsiveness to reduce acceleration and/or braking events and/or setting the driving route to a route requiring less braking by the vehicle when the regenerative braking level decreases.

In some instances, the at least one processor is further configured to: maintain the same regenerative braking level in response to a change in the battery data; and adjust the driving strategy based on a difference in battery charging amount due to the maintenance of the regenerative braking level.

In some examples, the at least one processor is further configured to: determine whether an increase in the regenerative braking level is required in a next period based on a change in the battery data in a current period; determine the regenerative braking level in the next period in the same manner as in the current period where it is determined that the increase is necessary; and adjust the driving strategy in the next period by reflecting a decrease amount in the battery charging amount due to the maintenance of the regenerative braking level.

Some aspects of the disclosure are directed to a vehicle comprising: a battery and a computing system.

Some aspects of the disclosure are directed to a method of controlling a vehicle, comprising: receiving, by one or more processors, battery data related to a battery of the vehicle; determining, by the one or more processors, a regenerative braking level of the vehicle based on the battery data; adjusting, by the one or more processors, a driving strategy of the vehicle based on the regenerative braking level; and controlling, by the one or more processors, driving of the vehicle based on the driving strategy.

In some instances, the battery data includes a state of charge (SOC) level of the battery, and wherein determining the regenerative braking level comprises determining the regenerative braking level based on a relationship inversely proportional to the SOC level.

In some examples, determining the regenerative braking level comprises: calculating a discharging amount of the SOC level based on driving of the vehicle and a charging amount of the SOC level based on regenerative braking of the vehicle, wherein the regenerative braking level is determined based on the discharging amount and the charging amount.

In some instances, determining the regenerative braking level includes maintaining the same regenerative braking level in response to a change in the battery data, and adjusting the driving strategy comprises adjusting the driving strategy in consideration of a difference in battery charging amount due to the maintenance of the regenerative braking level.

In some instances, adjusting the driving strategy of the vehicle based on the regenerative braking level includes adjusting one or more of a driving speed, driving route, driving responsiveness, or headway distance setting of the vehicle.

In some examples, adjusting the driving strategy of the vehicle based on the regenerative braking level includes, when the regenerative braking level increases, increasing the driving speed of the vehicle, decreasing the headway distance setting, increasing the driving responsiveness, and/or setting the driving route to a route requiring more braking by the vehicle.

In some examples, adjusting the driving strategy of the vehicle based on the regenerative braking level includes, when the regenerative braking level decreases, decreasing the driving speed of the vehicle, increasing the headway distance setting, decreasing the driving responsiveness to reduce acceleration and/or braking events, and/or setting the driving route to a route requiring less braking by the vehicle.

Some aspects of the disclosure are directed to a non-transitory computer readable medium storing instructions, which, when executed by at least one processor, causes the at least one processor to perform operations of: acquiring battery data related to a battery of a vehicle; determining a regenerative braking level of the vehicle based on the battery data; adjusting a driving strategy of the vehicle based on the regenerative braking level; and controlling driving of the vehicle based on the driving strategy.

According to some embodiments, a computing system may comprise an interface circuit; and at least one processor operatively coupled to the interface circuit, wherein the at least one processor is configured to acquire battery data related to a battery of a vehicle, determine a regenerative braking level of the vehicle based on the battery data, adjust a driving strategy of the vehicle based on the regenerative braking level, and control driving of the vehicle based on the regenerative braking level and the driving strategy.

According to some embodiments, the battery data may include a state of charge (SOC) level of the battery, and the at least one processor may be configured to determine the regenerative braking level based on a relationship inversely proportional to the SOC level.

According to some embodiments, the at least one processor may be configured to calculate a discharging amount of the SOC level according to driving of the vehicle and a charging amount of the SOC level according to regenerative braking of the vehicle; and determine the regenerative braking level based on the discharging amount and the charging amount.

According to some embodiments, the at least one processor may be configured to calculate a predicted discharging amount and predicted charging amount of the SOC level after a predetermined time has elapsed based on the discharging amount and the charging amount, determine a next level of the regenerative braking level based on the predicted discharging amount and the predicted charging amount, and maintain the next level until the predetermined time elapses.

According to some embodiments, the at least one processor may be configured to aggressively adjust the driving strategy in consideration of an increase in braking force of the vehicle in a situation where the regenerative braking level increases, and defensively adjust the driving strategy in consideration of a decrease in the braking force of the vehicle in a case where the regenerative braking level decreases.

According to some embodiments, the at least one processor may be configured to adjust the driving strategy by changing at least one of driving speed, driving route, driving responsiveness, or headway distance setting of the vehicle according to the increase or decrease in the regenerative braking level.

According to some embodiments, the at least one processor may be configured to maintain the same regenerative braking level in response to a change in the battery data, and adjust the driving strategy in consideration of a difference in battery charging amount due to the maintenance of the regenerative braking level.

According to some embodiments, the at least one processor may be configured to determine whether an increase in the regenerative braking level is required in a next period based on a change in the battery data in a current period, determine the regenerative braking level in the next period in the same manner as in the current period where it is determined that the increase is necessary, and adjust the driving strategy in the next period by reflecting a decrease amount in the battery charging amount due to the maintenance of the regenerative braking level.

According to some embodiments, a vehicle may comprise a battery; and a computing system configured to acquire battery data related to the battery, determine a regenerative braking level of a vehicle based on the battery data, adjust a driving strategy of the vehicle based on the regenerative braking level, and control driving of the vehicle based on the regenerative braking level and the driving strategy.

According to some embodiments, the battery data may include a state of charge (SOC) level of the battery, and the computing system may be configured to determine the regenerative braking level based on a relationship inversely proportional to the SOC level.

According to some embodiments, the computing system may be configured to calculate a discharging amount of the SOC level according to driving of the vehicle and a charging amount of the SOC level according to regenerative braking of the vehicle; and determine the regenerative braking level based on the discharging amount and the charging amount.

According to some embodiments, the computing system may be configured to calculate a predicted discharging amount and predicted charging amount of the SOC level after a predetermined time has elapsed based on the discharging amount and the charging amount, determine a next level of the regenerative braking level based on the predicted discharging amount and the predicted charging amount, and maintain the next level until the predetermined time elapses.

According to some embodiments, the computing system may be configured to aggressively adjusts the driving strategy in consideration of an increase in braking force of the vehicle in case where the regenerative braking level increases, and defensively adjust the driving strategy in consideration of a decrease in the braking force of the vehicle in case where the regenerative braking level decreases.

According to some embodiments, the computing system may be configured to adjust the driving strategy by changing at least one of driving speed, driving route, driving responsiveness, or headway distance setting of the vehicle according to the increase or decrease in the regenerative braking level.

According to some embodiments, the computing system may be configured to maintain the same regenerative braking level in response to a change in the battery data, and adjust the driving strategy in consideration of a difference in battery charging amount due to the maintenance of the regenerative braking level.

According to some embodiments, the computing system may be configured to determine whether an increase in the regenerative braking level is required in a next period based on a change in the battery data in a current period, determine the regenerative braking level in the next period in the same manner as in the current period where it is determined that the increase is necessary, and adjust the driving strategy in the next period by reflecting a decrease amount in the battery charging amount due to the maintenance of the regenerative braking level.

According to some embodiments, a method for operating a computing system may comprise operations of acquiring battery data related to a battery of a vehicle; determining a regenerative braking level of the vehicle based on the battery data; adjusting a driving strategy of the vehicle based on the regenerative braking level; and controlling driving of the vehicle based on the regenerative braking level and the driving strategy.

According to some embodiments, the battery data may include a state of charge (SOC) level of the battery, the operation of determining the regenerative braking level may include an operation of determining the regenerative braking level based on a relationship inversely proportional to the SOC level.

According to some embodiments, the operation of determining the regenerative braking level may include operations of calculating a discharging amount of the SOC level according to driving of the vehicle and a charging amount of the SOC level according to regenerative braking of the vehicle; and determining the regenerative braking level based on the discharging amount and the charging amount.

According to some embodiments, the operation of determining the regenerative braking level may include operations of calculating a predicted discharging amount and predicted charging amount of the SOC level after a predetermined time has elapsed based on the discharging amount and the charging amount; determining a next level of the regenerative braking level based on the predicted discharging amount and the predicted charging amount; and maintaining the next level until the predetermined time elapses.

According to some embodiments, the operation of adjusting the driving strategy may include operations of aggressively adjusting the driving strategy in consideration of an increase in braking force of the vehicle in case where the regenerative braking level increases; and defensively adjusting the driving strategy in consideration of a decrease in the braking force of the vehicle in case where the regenerative braking level decreases.

According to some embodiments, the operation of adjusting the driving strategy may include operation of adjusting the driving strategy by changing at least one of driving speed, driving route, driving responsiveness, or headway distance setting of the vehicle according to the increase or decrease in the regenerative braking level.

According to some embodiments, the operation of determining the regenerative braking level may include an operation of maintaining the same regenerative braking level in response to a change in the battery data, and the operation of adjusting the driving strategy may include operation of adjusting the driving strategy in consideration of a difference in battery charging amount due to the maintenance of the regenerative braking level.

According to some embodiments, the operation of determining the regenerative braking level may include operations of determining whether an increase in the regenerative braking level is required in a next period based on a change in the battery data in a current period; and determining the regenerative braking level in the next period in the same manner as in the current period where it is determined that the increase is necessary, the operation of adjusting the driving strategy may include operation of adjusting the driving strategy in the next period by reflecting a decrease amount in the battery charging amount due to the maintenance of the regenerative braking level.

According to some embodiments, a computer program stored in a computer readable medium, may comprise instructions which, when executed by at least one processor, causes the at least one processor to perform operations of acquiring battery data related to a battery of a vehicle; determining a regenerative braking level of the vehicle based on the battery data; adjusting a driving strategy of the vehicle based on the regenerative braking level; and controlling driving of the vehicle based on the regenerative braking level and the driving strategy.

According to some embodiments, the battery data may include a state of charge (SOC) level of the battery, the operation of determining the regenerative braking level may include an operation of determining the regenerative braking level based on a relationship inversely proportional to the SOC level.

According to some embodiments, the operation of determining the regenerative braking level may include operations of calculating a discharging amount of the SOC level according to driving of the vehicle and a charging amount of the SOC level according to regenerative braking of the vehicle; and determining the regenerative braking level based on the discharging amount and the charging amount.

According to some embodiments, the operation of determining the regenerative braking level may include operations of calculating a predicted discharging amount and predicted charging amount of the SOC level after a predetermined time has elapsed based on the discharging amount and the charging amount; determining a next level of the regenerative braking level based on the predicted discharging amount and the predicted charging amount; and maintaining the next level until the predetermined time elapses.

According to some embodiments, the operation of adjusting the driving strategy may include operations of aggressively adjusting the driving strategy in consideration of an increase in braking force of the vehicle in case where the regenerative braking level increases; and defensively adjusting the driving strategy in consideration of a decrease in the braking force of the vehicle in case where the regenerative braking level decreases.

According to some embodiments, the operation of adjusting the driving strategy may include operation of adjusting the driving strategy by changing at least one of driving speed, driving route, driving responsiveness, or headway distance setting of the vehicle according to the increase or decrease in the regenerative braking level.

According to some embodiments, the operation of determining the regenerative braking level may include an operation of maintaining the same regenerative braking level in response to a change in the battery data, and the operation of adjusting the driving strategy may include operation of adjusting the driving strategy in consideration of a difference in battery charging amount due to the maintenance of the regenerative braking level.

According to some embodiments, the operation of determining the regenerative braking level may include operations of determining whether an increase in the regenerative braking level is required in a next period based on a change in the battery data in a current period; and determining the regenerative braking level in the next period in the same manner as in the current period where it is determined that the increase is necessary, the operation of adjusting the driving strategy may include operation of adjusting the driving strategy in the next period by reflecting a decrease amount in the battery charging amount due to the maintenance of the regenerative braking level.

### ADVANTAGEOUS EFFECTS

According to some embodiments, a battery management system, a vehicle, a battery management method, and a computer program capable of considering regenerative braking of a vehicle when predicting a degree of degradation of a battery may be provided.

According to some embodiments, a computing system capable of determining a regenerative braking and/or driving strategy of a vehicle in consideration of degradation of a battery, a vehicle, a method for operating the computing system, and a computer program may be provided.

The effect of the present disclosure is not limited to the above-mentioned effects, and it should be understood to include all possible effects deduced from the configuration of the disclosure described in the detailed description or the claims of the present disclosure.

### DESCRIPTION OF DRAWINGS

FIG. 1 is a diagram illustrating a vehicle management system according to some embodiments disclosed herein.
FIG. 2 is a diagram illustrating a process of performing regenerative braking in a vehicle according to some embodiments disclosed herein.
FIG. 3 is a diagram illustrating components and functions of a battery according to some embodiments disclosed herein.
FIG. 4 is a diagram illustrating a process of predicting a degree of degradation of a battery based on an estimated level of regenerative braking according to some embodiments disclosed herein.
FIG. 5 is a diagram illustrating a degradation prediction model according to some embodiments disclosed herein.
FIG. 6 is a diagram illustrating operations constituting a battery management method according to some embodiments disclosed herein.
FIG. 7 is a diagram illustrating components and functions of a computing system according to some embodiments disclosed herein.
FIG. 8 is a diagram illustrating a process of determining a regenerative braking level and adjusting a driving strategy according to some embodiments disclosed herein.
FIG. 9 is a diagram illustrating a process of adjusting only a driving strategy while maintaining a regenerative braking level according to some embodiments disclosed herein.
FIG. 10 is a diagram illustrating operations constituting a method for operating a computing system according to some embodiments disclosed herein.

### Mode for Invention

The present disclosure will be described hereinafter with reference to the accompanying drawings. However, it is not intended to limit the present disclosure to specific embodiments, but should be understood to include various modifications, equivalents, and/or alternatives of the embodiments described herein.

It should be appreciated that embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd,", "first" and "second", "A", "B", "(a)" or "b" may be used to simply distinguish a corresponding component from another, and does not limit the components in other aspects (e.g., importance or order).

It is to be understood that if an element (e.g., a first element) is referred to, with or without the term "operatively" or "communicatively", as "connected to," "coupled to," or "contacted to" another element (e.g., a second element), it means that the element may be coupled with the other element directly (e.g., wiredly or wirelessly), or indirectly (e.g., via a third element).

A method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments of the disclosure, each component (e.g., a module or a program) of the above-described components may include a single entity or multiple entities, or some of the plurality of entities may be separately disposed in different components. According to various embodiments of the disclosure, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments of the disclosure, operations performed by the module, the program, or another component may be carried out sequentially, in parallel, repeatedly, or heuristically, or one or more of the operations may be executed in a different order or omitted, or one or more other operations may be added.

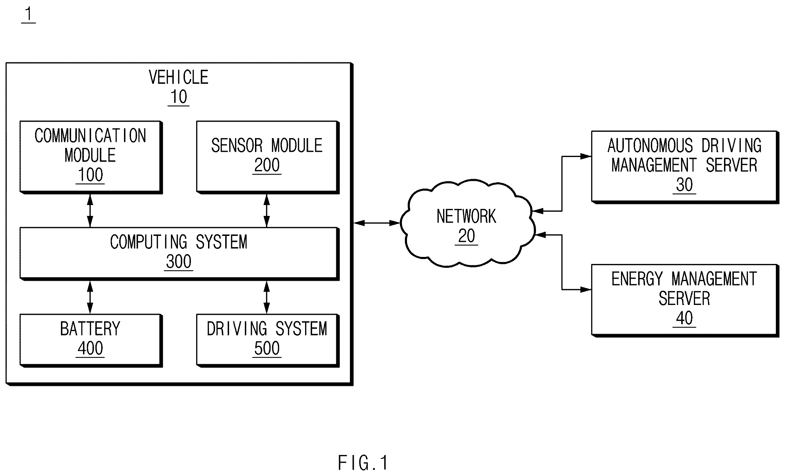

FIG. 1 is a diagram illustrating a vehicle management system according to some embodiments disclosed herein.

Referring to FIG. 1, a vehicle management system 1 may include a vehicle 10, a network 20, an autonomous driving management server 30 and an energy management server 40. For example, the vehicle management system 1 may refer to a system that manages the vehicle 10 by analyzing and/or managing data on driving and energy of the vehicle 10 collected through the network 20 by the autonomous driving management server 30 and the energy management server 40.

The vehicle 10 may include a communication module 100, a sensor module 200, a computing system 300, a battery 400 and a driving system 500. For example, the vehicle 10 may be an electric vehicle (EV) or a hybrid electric vehicle (HEV) that generates driving force using electrical energy. In addition, according to various embodiments, the vehicle 10 may include a vehicle equipped with an autonomous driving function, and the communication module 100, the sensor module 200, and the computing system 300 may be implemented in the form of an autonomous driving platform, but is not limited thereto.

The communication module 100 may exchange data with the outside of the vehicle 10. For example, the communication module 100 establishes a wired and/or wireless communication channel, and can exchange various data with the outside through the established communication channel. Particularly, the communication module 100 may access external devices of the vehicle 10 via the network 20.

The sensor module 200 may detect objects located around the vehicle 10. For example, the sensor module 200 may include a camera sensor for detecting surrounding objects, a global navigation satellite system (GNSS) sensor for assist in mapping, perception, occupancy grid generation, and/or path planning functions, and/or route planning functions, RADAR sensors for detecting nearby vehicles, ultrasonic sensors for parking assistance and/or occupancy grid generation, LIDAR sensors for object and pedestrian detection, emergency braking, collision avoidance, and/or other functions, inertial measurement unit (IMU) sensors that include accelerometers, magnetometers, gyroscopes, and/or magnetic compasses, a vibration sensor, a temperature sensor, and/or a speed sensor.

The computing system 300 may overall manage operations of the vehicle 10 and functions provided by the vehicle 10. To this end, the computing system 300 may control and/or manage the operations of the communication module 100, sensor module 200, battery 400 and/or driving system 500.

The computing system 300 may process various operations related to the vehicle 10 and may execute programs, software, or instructions. According to embodiments, the computing system 300 may process calculations related to driving control of the vehicle 10 and/or calculations related to energy management functions. For example, the calculations related to driving control of the vehicle 10 may include the calculations for judging/determining a driving strategy, a driving route, movement, etc. of the vehicle 10. According to some embodiments, the computing system 300 may determine the regenerative braking level of the vehicle 10 based on battery data including a state of charge (SOC) of the battery 400, etc., and may adjust the driving strategy of the vehicle 10 based on the regenerative braking level.

The computing system 300 may include at least one processor for arithmetic processing and instruction execution and an interface circuit for interacting with other components of the vehicle 10. According to embodiments, the communication scheme of the interface circuit may be a device-to-device communication scheme such as a bus, general purpose input and output (GPIO), serial peripheral interface (SPI), or mobile industry processor interface (MIPI).

The at least one processor of the computing system 300 may have a structure for executing instructions implementing the processes processed inside the vehicle 10. The at least one processor may be implemented as a general-purpose microprocessor or array of multiple logic gates for processing various operations, and may be composed of a single processor or a plurality of processors. For example, the at least one processor may be implemented in the form of a microprocessor, a central processing unit (CPU), a graphic processor unit (GPU), an application processor (AP), application specific integrated process (ASIC), or combinations thereof.

The at least one processor of the computing system 300 may be separately or integrally configured with a memory (not illustrated) configured to store instructions, and may process various operations by executing instructions stored in the memory. The memory may store various data, instructions, mobile applications, computer programs, and the like. For example, the memory may be implemented as non-volatile memory such as ROM, PROM, EPROM, EEPROM, flash memory, PRAM, MRAM, RRAM, FRAM, etc., or volatile memory such as DRAM, SRAM, SDRAM, PRAM, RRAM, FeRAM, etc. or may be implemented in the form of HDD, SSD, SD, Micro-SD, etc., or a combination thereof. In some instances, the computing system 300 may be implemented as a system-on-chip (SoC).

The battery 400 may supply power and/or electrical energy to the vehicle 10. For example, the battery 400 may be a rechargeable secondary battery that is discharged while supplying power to the vehicle 10 and charged by a battery charging device, and may be, for example, a lithium ion battery, but is not limited thereto. According to some embodiments, the battery 400 may be charged by regenerative braking of the vehicle 10. According to some embodiments, the battery 400 may include battery cells, battery modules, battery packs, and/or battery racks, and may include a battery management system (BMS) that manages battery cells, battery modules, battery packs, and the like.

The battery management system (BMS) may be a battery management system that manages the overall operation/function of the battery 400. According to embodiments, the battery management system (BMS) may process an operation related to an energy management function, and in some cases, the battery management system (BMS) may provide arithmetic results to the computing system 300. According to some embodiments, the battery management system of the battery 400 may determine whether regenerative braking of the vehicle 10 occurs and predict a degree of degradation of the battery pack based on data related to the regenerative braking.

The driving system 500 may control driving and/or movement of vehicle 10. For example, the driving system 500 may control operations of actuators related to braking, driving, and attitude of the vehicle 10. According to some embodiments, the driving system 500 may include a braking system that controls the operation of actuators related to braking, a posture control system that controls the operation of actuators to stably maintain the posture of the vehicle body, a steering system that controls the operation of an actuator for controlling the vehicle's lateral movement, a transmission system that controls the operation of an actuator for automatic transmission, and/or an engine management system that controls the operation of an actuator for controlling the driving speed of a vehicle, but is not limited thereto no.

According to some embodiments, the driving system 500 may control driving and/or movement of the vehicle 10 in response to a control instruction from the computing system 300. For example, the driving system 500 may control driving and/or movement of the vehicle 10 in response to a control instruction based on the arithmetic result of the computing system 300 (e.g., the arithmetic/execution result of autonomous driving software). According to some embodiments, the driving system 500 may drive the vehicle 10 based on the regenerative braking level and driving strategy set by the computing system 300.

The network 20 may refer to a data communication network supporting communication between the vehicle 10, the autonomous driving management server 30, and the energy management server 40. For example, the network 20 may include a wired network, a wireless network, or a combination thereof, but is not limited thereto and may be a different type of network to the extent of supporting data exchange. According to some embodiments, the wired network may include a local area or wide area Internet that supports the TCP/IP protocol. The wireless network may include a wireless communication network based on a base station, a satellite communication network, a local area wireless communication network such as Wi-Fi, or a combination thereof.

According to some embodiments, the network 20 may include 2G to 5G networks, an LTE network, global system for mobile communication (GSM) network, code division multiple accesses (CDMA) network, evolution-data optimization (EVDO) network, public land mobile network, and/or other networks. According to some embodiments, the network 20 may include local area network (LAN), wireless local area network (WLAN), wide area network, metropolitan network (MAN), public switched telephone network (PSTN), ad hoc network, managed IP network, virtual private network, intranet, Internet, fiber-based network, and /or combinations thereof, or other types of networks.

According to some embodiments, the autonomous driving management server 30 and the energy management server 40 may include a communication module, a processor, a database, and the like. The autonomous driving management server 30 and the energy management server 40 may acquire vehicle-related data from the vehicle 10 through a communication module. For example, the vehicle-related data may include driving data related to driving of the vehicle 10 and/or battery data related to the battery 400 of the vehicle 10. The autonomous driving management server 30 and the energy management server 40 may record vehicle-related data provided from the vehicle 10 in a database. For example, the processor of the autonomous driving management server 30 or energy management server 40 may include a central processing unit (CPU), an application processor (AP), a graphic processing unit (GPU), a neural network processing unit (NPU), and an image signal processor, etc., and may perform various data processing or arithmetic operation.

According to some embodiments, the autonomous driving management server 30 may support updates of autonomous driving software installed in the vehicle 10, navigation map updates, driving control of the vehicle 10, and the like, and may store the driving data, black box video data, etc. provided from the vehicle 10 for a certain period of time. In addition, the autonomous driving management server 30 may be configured to perform various functions related to processing, management, and storage of information or data related to driving of the vehicle 10.

According to some embodiments, the driving control for the vehicle 10 may mean controlling driving-related variables such as the position, speed, acceleration, driving direction, RPM of engine/motor, transmission ratio, suspension damping, and regenerative braking level of the vehicle 10, based on the driving data of the vehicle 10. For example, the driving data may include object data about objects around the vehicle 10 and movement data about the movement of the vehicle 10. According to some embodiments, the object data may include the type and number of surrounding objects, distance to the vehicle 10, location relative to the vehicle 10, ground location, relative speed, ground speed, relative acceleration, ground acceleration, and the like. The movement data may include the location, movement path, travel distance, speed, acceleration, steering angle, yaw, pitch, roll, and the like of the vehicle 10.

According to some embodiments, the autonomous driving management server 30 may perform driving control of the vehicle 10 by remotely controlling acceleration, deceleration, steering, and a combination thereof of the vehicle 10. According to some embodiments, the autonomous driving management server 30 may execute driving control software that remotely controls driving of the vehicle 10. For example, the driving control software may provide, to the computing system 300 of the vehicle 10, the instructions for controlling the driving system 500 based on driving data provided from the communication module 100 and/or sensor module 200 of the vehicle 10. Meanwhile, the driving control software may additionally consider battery data provided from the battery 400 when performing driving control of the vehicle 10.

According to some embodiments, the energy management server 40 may support updating of energy management software installed in the vehicle 10, machine learning for an energy-related artificial intelligence model, and the like, and may store the battery data provided from the vehicle 10, artificial intelligence model parameters, etc. for a certain period of time. In addition, the energy management server 40 may be configured to perform various functions related to processing, management, and storage of information or data related to the battery 400 of the vehicle 10.

According to some embodiments, the energy management function performed for the vehicle 10 may mean an operation of generating and/or providing the status diagnosis, life prediction, operation control (e.g., cell balancing), charging guide, etc. of the battery 400, based on the battery data provided from the battery 400 of the vehicle 10. For example, the battery data may include voltage data, current data, temperature data, state of charge (SOC) data, state of health (SOH) data, and combinations thereof, and may further include cumulative charging current amount, cumulative discharging current amount, cumulative charging power, cumulative discharging power, insulation resistance, relay state, and the like.

According to some embodiments, the energy management server 40 may perform an energy management function for the vehicle 10 by remotely generating and/or providing status diagnosis, life prediction, operation control (e.g., cell balancing), charging guide, etc. of the battery 400. According to some embodiments, the energy management server 40 may execute energy management software for remotely managing the battery 400 of the vehicle 10. For example, the energy management software may transmit instructions for performing energy management functions based on the battery data provided from a battery management system (BMS) of the battery 400 to the computing system 300 or BMS of battery 400 of the vehicle 10. Meanwhile, the energy management software may additionally consider driving data provided from the communication module 100 and/or the sensor module 200 when performing the energy management function for the vehicle 10.

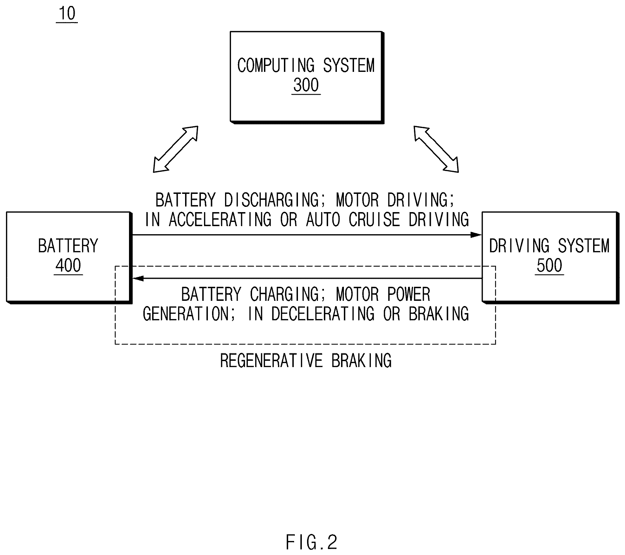

FIG. 2 is a diagram illustrating a process of performing regenerative braking in a vehicle according to some embodiments disclosed herein.

Referring to FIG. 2, in the vehicle 10, the computing system 300 controls the battery 400 and the driving system 500, so that the discharging of the battery 400 according to the driving of the vehicle 10 and the charging of the battery 400 according to the braking of the vehicle 10 may be performed.

According to some embodiments, the computing system 300 may control the battery 400 to supply electrical energy to the driving system 500. The driving system 500 may drive a motor using the electrical energy supplied from the battery 400. According to some embodiments, the driving system 500 may include one or more electric motors. When the motor is driven, the vehicle 10 may be accelerated, and even in the case of the auto cruise of the vehicle 10, the battery 400 may be discharged to drive the motor.

According to some embodiments, the computing system 300 may control the driving system 500 to charge the battery 400 while the vehicle 10 decelerates. For example, the computing system 300 may control the driving system 500 so that the braking device of the driving system 500 operates or the motor does not generate driving force. When the motor rotates together with the wheels of the driving system 500 without receiving a separate driving force, electric energy may be generated from the motor by the principle of electromagnetic induction. According to some embodiments, the regenerative braking may refer to a braking method in which the battery 400 is charged using the electric energy generated from a motor when the vehicle 10 is braked or decelerated.

In general, in the case of a rechargeable secondary battery, considering that the lifespan of the battery 400 may decrease when charging and discharging are repeated, in the case where regenerative braking is performed, the battery 400 repeats discharging and charging, so that the performance of the battery 400 may be degraded. The regenerative braking may have an advantage in terms of a driving distance of the vehicle 10 or a charging cost of the battery 400, but may be disadvantageous in terms of performance or lifespan of the battery 400. Therefore, a management technique that takes advantage of the regenerative braking of the vehicle 10 and at the same time considers the degradation of the battery 400 may be required.

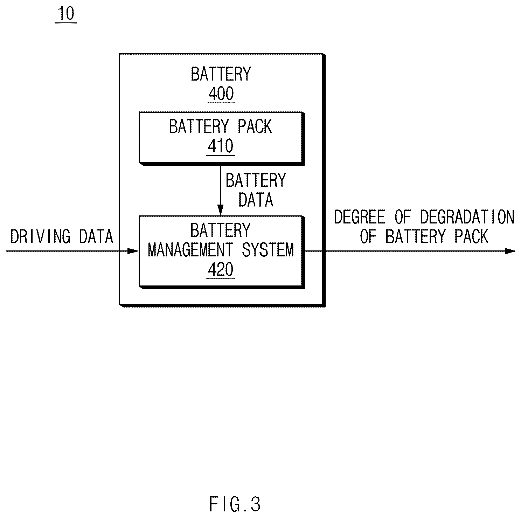

FIG. 3 is a diagram illustrating components and functions of a battery according to some embodiments disclosed herein.

Referring to FIG. 3, a battery 400 may include a battery pack 410 and a battery management system 420. However, the battery 400 is not limited thereto, and some components may be omitted from the battery 400 or other general-purpose components may be added to the battery 400. According to some embodiments, the battery 400 may predict a degree of degradation of the battery pack 410 based on driving data and battery data.

According to some embodiments, the battery management system 420 may include at least one controller or at least one processor. At least one controller/processor of the battery management system 420 may have a structure for processing various operations, processes, and instructions. According to some embodiments, at least one controller/processor of the battery management system 420 may be separately or integrally configured with a memory (not illustrated), and may process various operations by executing instructions stored in the memory.

According to some embodiments, the battery management system 420 may predict the degree of degradation of the battery pack 410 based on the battery data measured by the battery pack 410 and driving data measured by the communication module 100 and/or sensor module 200 of the vehicle 10. According to some embodiments, functions and/or operations performed by the controller below may be interpreted as being performed by the battery management system 410 in the vehicle 10.

According to some embodiments, the battery management system 420 may include a data acquirer. The data acquirer may be configured to acquire driving data related to driving of the vehicle 10 and battery data related to the battery pack 410 of the vehicle 10. For example, the data acquirer of the battery management system 420 may include an interface circuit for interacting with other components of the vehicle 10, and the communication scheme of the data acquirer may be a device-to-device communication scheme such as a bus, GPIO, SPI, MIPI.

The data acquirer of the battery management system 420 may be configured to acquire driving data related to driving of the vehicle 10 and battery data related to the battery pack 410. According to some embodiments, the driving data may include object data about objects around the vehicle 10 and movement data about the movement of the vehicle 10, the object data may include type and number of surrounding objects, distance to the vehicle 10, location relative to the vehicle 10, ground location, relative speed, ground speed, relative acceleration, ground acceleration, or the like, and the movement data may include the location, movement path, travel distance, speed, acceleration, steering angle, yaw, pitch, roll of the vehicle 10, or the like. According to some embodiments, the battery data may include voltage data, current data, temperature data, state of charge (SOC) data, state of health (SOH) data, and combinations thereof, and may further include cumulative charging current amount, cumulative discharging current amount, cumulative charging power, cumulative discharging power, insulation resistance, relay state, or the like.

The controller of the battery management system 420 may be configured to determine whether regenerative braking of the vehicle 10 occurs based on driving data and battery data. According to some embodiments, it may be determined that regenerative braking occurs in the case where the SOC level of the battery pack 410 increases while the vehicle 10 is decelerating. On the other hand, even if the SOC level increases, it may be determined that regenerative braking does not occur in the case where the vehicle 10 is not driving or a battery charger is connected to the vehicle 10.

The controller of the battery management system 420 may be configured to derive statistical data related to the occurrence of regenerative braking. According to some embodiments, the controller may be configured to derive charging data related to charging of the battery pack 410 by regenerative braking. According to some embodiments, the statistical data may include the number of occurrences of regenerative braking, the frequency of regenerative braking, the duration of regenerative braking, and statistical variables derived therefrom. According to some embodiments, the charging data may include a variation amount of the SOC level of the battery pack 410, a voltage variation amount, a current variation amount, a temperature variation amount, and a battery-related variable derived therefrom.

The controller of the battery management system 420 may be configured to predict the degree of degradation of the battery pack 410 based on the statistical data. According to some embodiments, the controller may be configured to predict the degree of degradation of the battery pack 410 based on the statistical data and the charging data. According to embodiments, the degree of degradation of the battery pack 410 may include a degree of degradation due to driving of the vehicle 10 and a degree of degradation due to regenerative braking regardless of regenerative braking. According to some embodiments, the degree of degradation due to regenerative braking may increase as regenerative braking occurs more frequently, the frequency of regenerative braking increases, the duration of regenerative braking increases, and the variation range of charging data increases, and may be expressed as a numerical value related to a ratio of degraded performance based on the maximum performance of the battery pack 410.

According to some embodiments, the controller of the battery management system 420 may be configured to predict the degree of degradation based on the number of occurrences of regenerative braking according to statistical data and the amount of charge of the battery pack 410 according to charging data. The number of occurrences of regenerative braking may be counted based on the statistical data, and an increase in the SOC level of the battery pack 410 due to each regenerative braking may be calculated as a charging amount. According to some embodiments, as the number of occurrences of regenerative braking increases and the amount of charge of the battery pack 410 due to regenerative braking increases, the degree of degradation may be predicted to be a higher value.

According to some embodiments, the controller of the battery management system 420 may be configured to acquire whether the charger is connected, indicating whether or not the battery charger is connected to the vehicle 10, and determine whether regenerative braking of the vehicle 10 occurs based on driving data, battery data, and whether the charger is connected. According to some embodiments, in the case where the battery charger is connected, even if regenerative braking is not performed, the remaining amount of the battery pack 410 may be charged, and thus whether regenerative braking has occurred may be determined more accurately.

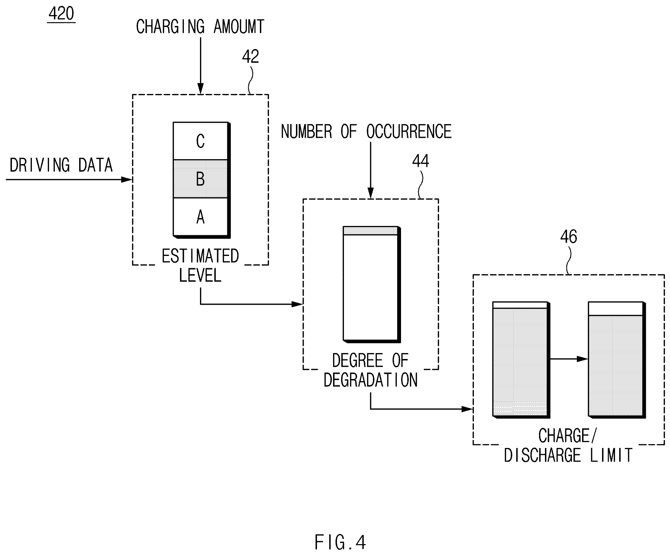

FIG. 4 is a diagram illustrating a process of predicting a degree of degradation of a battery based on an estimated level of regenerative braking according to some embodiments disclosed herein.

Referring to FIG. 4, the battery management system 420 may calculate an estimated level 42 based on the driving data of the vehicle 10 and the amount of charge of the battery pack 410, may predict a degree of degradation 44 of the battery pack 410 based on the number of occurrences of regenerative braking and the estimated level 42, and may perform a charge/discharge limit 46 of the battery pack 410 based on the degree of degradation 44.

According to some embodiments, the controller of the battery management system 420 may be configured to calculate the estimated level 42 of regenerative braking based on the driving data and the amount of charge, and predict the degree of degeneration 44 based on the number of occurrences and the estimated level 42. The regenerative braking of the vehicle 10 may be performed according to a regenerative braking level. In this regard, the computing system 300 of the vehicle 10 may determine a regenerative braking level. According to some embodiments, the regenerative braking level may include 3 levels of 1 to 3, A to C, etc. In other embodiments, the regenerative braking level may include 5 levels, 8 levels, 10 levels, or any other number of levels, and, in some instances, the regenerative braking level may be set to a continuous value instead of a discrete value.

The controller of the battery management system 420 may predict the value of the regenerative braking level determined by the computing system 300 or may receive the determined value of the regenerative braking level from the computing system 300. According to some embodiments, the regenerative braking level may be predicted based on driving data and a charging amount. For example, in the case where the driving data indicates that the vehicle 10 is decelerating moderately and the charging amount indicates that the battery pack 410 is moderately charged, the estimated level 42 of regenerative braking may be predicted as B of levels A to C.

After the estimated level 42 of regenerative braking is determined, the degree of degradation 44 of the battery pack 410 may be determined according to how much regenerative braking occurs with the determined estimated level 42. According to some embodiments, the higher the estimated level 42 and the higher the number of occurrences of regenerative braking, the higher the degree of degradation 44 may be calculated. If the estimated level 42 of regenerative braking is changed, the number of occurrences at the changed level may be newly counted.

According to some embodiments, the controller of the battery management system 420 may be further configured to limit at least one of discharging of the battery pack 410 by driving of the vehicle 10 or charging of the battery pack 410 by regenerative braking according to a predetermined ratio, based on the number of occurrences and the estimated level. According to some embodiments, the degree of degradation 44 may be calculated based on the number of occurrences and the estimated level, and if the degree of degradation 44 exceeds a threshold value of degradation, the charge/discharge limit 46 may be applied to the battery pack 410.

When the charge/discharge limit 46 is applied, a portion of the charge of the battery pack 410 is limited so that only a portion of the power generated by regenerative braking is delivered to the battery pack 410, or the computing system 300 may set the regenerative braking level to a certain level or less. In addition, some of the discharge of the battery pack 410 is limited, and thus the output of the driving system 500 may decrease, and thus the speed or acceleration of the vehicle 10 may decrease. According to the charge/discharge limit 46, excessive repetition of charging and discharging of the battery pack 410 can be prevented, and thus degradation of the battery pack 410 can be reduced.

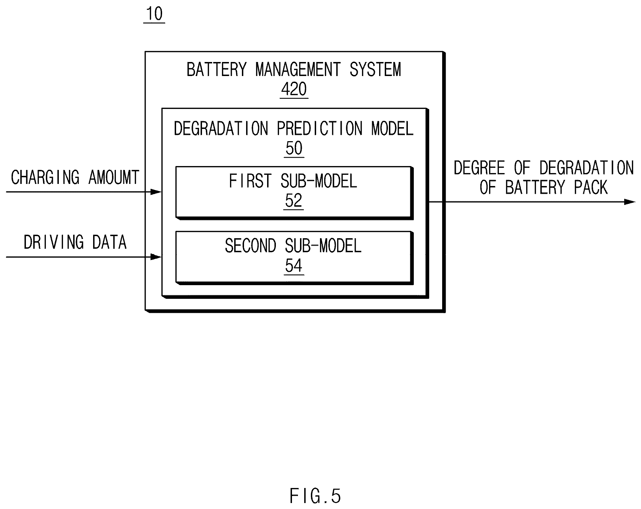

FIG. 5 is a diagram illustrating a degradation prediction model according to some embodiments disclosed herein.

Referring to FIG. 5, the controller of the battery management system 420 may predict the degree of degradation of the battery pack 410 from the charging amount and driving data using a degradation prediction model 50, and the degradation prediction model 50 may include a first sub-model 52 and a second sub-model 54.

According to some embodiments, the controller of the battery management system 420 may be configured to predict a degree of degradation using the degradation prediction model 50, and the degradation prediction model 50 may include the first sub-model 52 trained to calculate an estimated level and the second sub-model 54 trained to predict the degree of degradation. According to some embodiments, the degradation prediction model 50 may calculate the estimated level of regenerative braking based on the driving data and the charging amount through the first sub-model 52, and may predict the degree of the degradation of the battery pack 410 based on the estimated level and the number of occurrences through the second sub-model 54.

According to some embodiments, the degradation prediction model 50 may be an AI model that is trained and updated through various machine learning techniques based on a neural network structure. The degradation prediction model 50 may determine model parameters through machine learning with a known relationship between charging amount, driving data, and degree of degradation as learning data. Then, model parameters may be continuously optimized as driving of the vehicle 10 is accumulated.

According to some embodiments, the controller of the battery management system 420 may be configured to acquire the regenerative braking level of regenerative braking determined by the computing system 300 of the vehicle 10 and compare the estimated level with the regenerative braking level to update the first sub-model 52. If the regenerative braking level actually determined by the computing system 300 can be utilized, the first sub-model 52 predicting the estimated level of regenerative braking may be updated. For example, in the case where a difference between the estimated level of the first sub-model 52 and the actual regenerative braking level occurs, the first sub-model 52 may be trained so as to reduce the difference. Accordingly, the performance of the first sub-model 52 may be improved, and even if an actual regenerative braking level is not provided later, the first sub-model 52 may provide an accurate estimated level.

According to some embodiments, the controller of the battery management system 420 may be configured to transmit the number of occurrences and the estimated level to the energy management server 40 outside the vehicle 10, and receive a predicted degree of degradation based on the number of occurrences and the estimated level through the degradation prediction model by the energy management server 40. According to some embodiments, the degradation prediction model 50 may be operated by the energy management server 40 instead of the battery management system 420. To this end, the battery management system 420 may provide the energy management server 40 with data to be input into the degradation prediction model 50, and the energy management server 40 may provide the battery management system 420 with the predicted result of the degradation prediction model 50. When the degradation prediction model 50 is operated by the external energy management server 40 in this way, model inference operations and model updates requiring a high amount of computation can be smoothly performed.

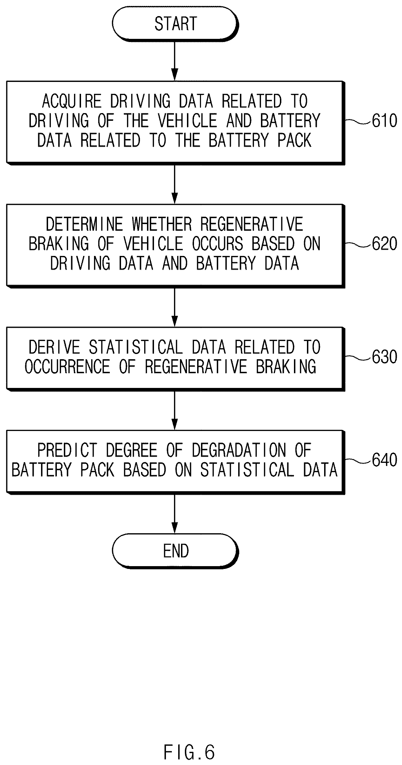

FIG. 6 is a diagram illustrating operations constituting a battery management method according to some embodiments disclosed herein.

Referring to FIG. 6, a battery management method 600 may include operations 610 to 640. However, the method is not limited thereto, and some operations may be omitted or general-purpose operations may be added, and operations of the battery management method 600 may be executed in a different order from the illustrated order.

Operations 610 to 640 in the battery management method 600 may be performed by the battery management system 420 of the battery 400. According to some embodiments, the battery management method 600 may include operations processed time-sequentially in the battery management system 420. Therefore, the description of the battery management system 420 above may be equally applied to the battery management method 600 even if the description is omitted below.

**In** operation 610, the battery management system 420 may acquire driving data related to driving of the vehicle and battery data related to the battery pack through the data acquirer.

**In** operation 620, the battery management system 420 may determine whether regenerative braking of the vehicle occurs based on driving data and battery data through the controller.

**In** operation 630, the battery management system 420 may derive the statistical data related to occurrence of regenerative braking through the controller.

**In** operation 640, the battery management system 420 may predict the degree of degradation of the battery pack based on the statistical data through the controller.

According to some embodiments, the battery management method 600 may be implemented in the form of a computer program stored in a computer-readable storage medium. That is, the computer program may include instructions for implementing the battery management method 600, and the instructions of the program may be stored in a computer-readable storage medium. The computer program may include a mobile application.

For example, the computer-readable media may include magnetic media such as hard disks, floppy disks, and magnetic tape; optical media such as CD-ROMs and DVDs; magneto-optical media such as floptical disks; and hardware devices that are specially configured to store and perform program instructions, such as ROM, RAM, flash memory, and the like. Program instructions may include both machine codes produced by a compiler, and higher level codes that may be executed by the computer using an interpreter.

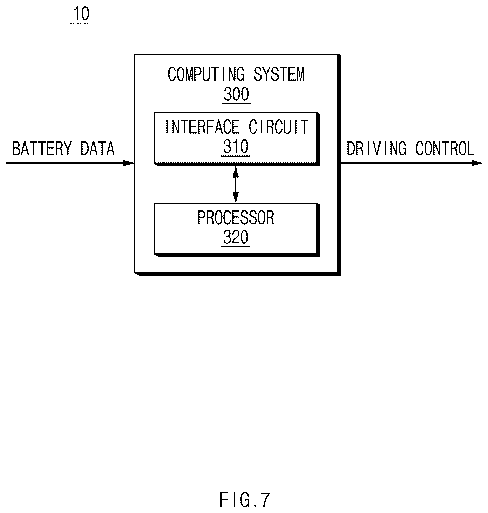

FIG. 7 is a diagram illustrating components and functions of a computing system according to some embodiments disclosed herein.

Referring to FIG. 7, the computing system 300 may include an interface circuit 310 and at least one processor 320. However, the computing system 300 is not limited thereto, and some components may be omitted from the computing system 300 or other general-purpose components may be added to the computing system 300.

According to some embodiments, the at least one processor 320 may determine the regenerative braking level and driving strategy of the vehicle 10 based on the battery data measured by the battery pack 410, and may control the driving of the vehicle 10 based on the regenerative braking level and driving strategy. According to some embodiments, the functions and/or operations performed by the at least one processor 320 below may be interpreted as being performed by the computing system 300 in the vehicle 10.

The at least one processor 320 may be configured to acquire battery data related to battery 400 of vehicle 10. The battery management system 420 of the battery 400 may measure battery data from the battery pack 410 and provide the measured battery data to the computing system 300. According to some embodiments, the battery data may include voltage data, current data, temperature data, state of charge (SOC) data, state of health (SOH) data, and combinations thereof, and may further include cumulative charging current amount, cumulative discharging current amount, cumulative charging power, cumulative discharging power, insulation resistance, relay state, and the like.

The at least one processor 320 may be configured to determine a regenerative braking level of vehicle 10 based on battery data. The regenerative braking level may refer to an operation in which regenerative braking of the vehicle 10 is performed, and the higher the regenerative braking level, the greater the braking force of the vehicle 10 and the amount of charge of the battery 400. According to some embodiments, the regenerative braking level may include 3 levels such as 1 to 3, A to C, etc. In other embodiments, the regenerative braking level may include 5 levels, 8 levels, 10 levels, or any other number of levels, and, in some instances, the regenerative braking level may be set to a continuous value instead of a discrete value.

The at least one processor 320 may be configured to adjust a driving strategy of vehicle 10 based on the regenerative braking level. The driving strategy may refer to a strategy for driving the vehicle 10 in consideration of a braking force of a given regenerative braking level. According to some embodiments, the driving strategy of the vehicle 10 may include driving speed, driving acceleration, driving route, driving responsiveness, headway distance setting, strength of passing a bump, and the like. For example, when the regenerative braking level is relatively low, a route having a high proportion of simple driving sections may be selected, and the headway distance maintained by the vehicle 10 with respect to the vehicle in front may be set to be relatively long.

The at least one processor 320 may be configured to control driving of the vehicle 10 based on the regenerative braking level and the driving strategy. The driving system 500 may reduce the speed of the vehicle 10 with a braking force corresponding to a regenerative braking level, and drive the vehicle 10 according to the acceleration force, driving route, and headway distance setting corresponding to a driving strategy. For example, in the case where the regenerative braking level is set relatively high, a complicated path requiring a large amount of braking may be set as the driving path of the vehicle 10, and high driving responsiveness and short inter-vehicle distance may be employed.

Since the regenerative braking level may be determined based on the battery data of the battery 400, in the case where a high level of regenerative braking is unnecessary considering the battery data, the regenerative braking level may be limited to a low level. Accordingly, degradation of the battery 400 due to unnecessarily excessive regenerative braking may be prevented.

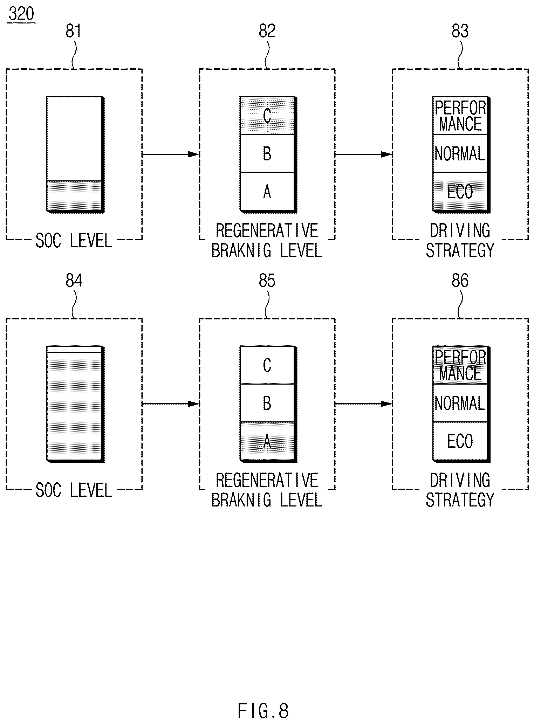

FIG. 8 is a diagram illustrating a process of determining a regenerative braking level and adjusting a driving strategy according to some embodiments disclosed herein.

Referring to FIG. 8, the at least one processor 320 may determine regenerative braking levels 82 and 85 based on the SOC levels 81 and 84 of the battery 400, and may determine driving strategies 83 and 86 based on the regenerative braking levels 82 and 85.

According to some embodiments, the battery data may include state of charge (SOC) levels 81 and 84 of the battery 400, and the at least one processor 320 may be configured to determine the regenerative braking level 82, 85 based on a relationship inversely proportional to the SOC levels 81 and 84. According to some embodiments, the SOC levels 81 and 84 may be estimated by the battery management system 420 based on the voltage, current, and/or temperature measured from the battery pack 410 of the battery 400, or may be estimated by the at least one processor 320.

The regenerative braking levels 82 and 85 may be determined based on a relationship inversely proportional to the SOC levels 81 and 84. According to some embodiments, the SOC levels 81 and 84 may be divided into high/middle/low, and the regenerative braking levels 82 and 85 of A/B/C may be determined in inverse proportion to the high/middle/low levels. Here, the inverse relationship may encompass all of the following relationships without limitation: when the SOC levels 81 and 84 increase, the regenerative braking levels 82 and 85 decrease, and when the SOC levels 81 and 84 decrease, the regenerative braking levels 82 and 85 increase. Meanwhile, the high/middle/low SOC levels 81 and 84 and the A/B/C regenerative braking levels 82 and 85 are only examples, and other classification methods may be used.

According to some embodiments, the driving strategies 83 and 86 may be determined in various ways based on the regenerative braking levels 82 and 85. First, in the case where the battery 400 is given priority, when the regenerative braking levels 82 and 85 are set to be high, the driving strategies 83 and 86 may be set in a direction of lowering the amount of discharge of the battery 400. Conversely, in the case where the driving of the vehicle 10 is given priority, when the regenerative braking levels 82 and 85 are set to be high, the driving strategies 83 and 86 may be set to a sport mode, etc. capable of utilizing high braking force. On the other hand, the driving strategies 83 and 86 are divided into performance/normal/eco strategies with respect to the driving performance of the vehicle 10 and the efficiency of the battery 400, but different dividing operations and dividing criteria may be used to the extent that the regenerative braking levels 82 and 85 are considered.

According to some embodiments, the at least one processor 320 may adjust the driving strategy in consideration of an increase in the braking force of the vehicle 10 in the case where the regenerative braking level increases to leverage the increase in braking force. For example, when the regenerative braking level is increased, the driving speed may increase and/or the headway distance may decrease as the increased braking level provides the vehicle with more braking power. Thus, the vehicle may stop more quickly compared to when the braking level is at a lower level. The at least one processor 320 may adjust the driving strategy in consideration of a decrease in the braking force of the vehicle 10 in the case where the regenerative braking level decreases, to account for the decrease in braking force. For example, when the regenerative braking level is set to a lower level, the driving speed may decrease and/or the headway distance may increase as the decreased braking level reduces the braking power available to the vehicle. Thus, the vehicle may be slower to stop compared to when the braking level is set to a higher level.

According to some embodiments, the at least one processor 320 may be configured to adjust the driving strategy by changing at least one of the driving speed, driving route, driving responsiveness, and headway distance setting of the vehicle 10 according to an increase or decrease of the regenerative braking level. For example, in the case where the driving strategy is Eco, the driving speed is reduced, the driving route is set to a simple route requiring less braking, the driving responsiveness is set low to reduce repetition of acceleration and deceleration, and the inter-vehicle distance is set long due to a low braking force.

According to some embodiments, the at least one processor 320 may be configured to calculate a discharging amount of a SOC level according to driving of the vehicle 10 and a charging amount of a SOC level according to regenerative braking of the vehicle 10, and determine the regenerative braking level based on the discharging amount and the charging amount. Since the battery 400 repeats charging due to deceleration of the vehicle 10 and discharging due to acceleration of the vehicle 10, it may be necessary to consider both the charging amount and the discharging amount. According to some embodiments, the charging amount and discharging amount of the SOC level may be calculated for a specific time such as 5 minutes, 3 minutes, 2 minutes, 1 minute, 30 seconds, 20 seconds, 15 seconds, 10 seconds, 5 seconds, etc., and the regenerative braking level may be determined based on the calculated charging and discharging amounts. For example, the regenerative braking level may be determined by comparing a ratio of the charging amount to the discharging amount for a specific time with threshold ratios.

According to some embodiments, the at least one processor 320 may be configured to calculate a predicted discharging amount and a predicted charging amount at a SOC level after a predetermined time has elapsed based on the discharging amount and the charging amount, determine the next level of the regenerative braking level based on the predicted discharging amount and the predicted charging amount, and maintain the next level until a predetermined time elapses. For example, the charging amount and discharging amount for a specific time such as 5 minutes, 3 minutes, 2 minutes, 1 minute, 30 seconds, etc. may be calculated, and the predicted discharging amount and predicted charging amount of the SOC level after a predetermined time has elapsed may be calculated based on the calculation. According to some embodiments, the predetermined time may be 5 minutes, 3 minutes, 2 minutes, 1 minute, 30 seconds, 20 seconds, 15 seconds, 10 seconds, 5 seconds, and the like. For example, the predicted discharging amount after the predetermined time of 5 minutes has elapsed may be set equal to the discharging amount during a specific time of 5 minutes. According to some embodiments, when calculating the predicted discharging amount and the predicted charging amount, the GPS location of the vehicle 10, the navigation driving information, or the like may be additionally considered.

A next level of the regenerative braking level may be determined based on a predicted discharging amount and a predicted charging amount. The next level may be set equal to a previous regenerative braking level, or greater or lesser to the previous regenerative braking level. For example, when a predicted discharging amount is predicted to be greater than a current discharging amount and a predicted charging amount is predicted to be less than a current charging amount, a next level may be set higher than a previous regenerative braking level to offset a decrease in the SOC level of the battery 400. After the next level is set, a set level may be maintained for a predetermined time.

According to some embodiments, a predicted discharging amount and predicted charging amount may be predicted based on a SOC level prediction model. The SOC level prediction model may be an AI model that is trained and updated through various machine learning techniques based on a neural network structure, and model parameters may be updated by comparing the predicted discharge and charging amounts with actually measured discharging and charging amounts. According to some embodiments, the SOC level prediction model may be managed by the energy management server 40 instead of the at least one processor 320.

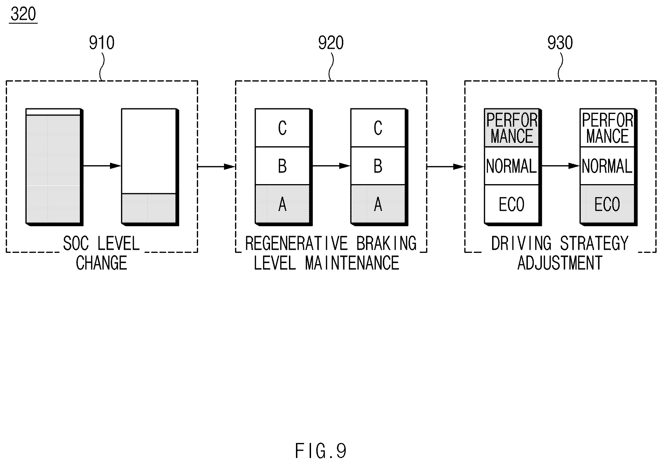

FIG. 9 is a diagram illustrating a process of adjusting only a driving strategy while maintaining a regenerative braking level according to some embodiments disclosed herein.

Referring to FIG. 9, even if a SOC level change 910 is occurred, the at least one processor 320 does not change the regenerative braking level as in a regenerative braking level maintenance 920 but may adjust the driving strategy as in a driving strategy adjustment 930. In this way, the regenerative braking level may be prevented from being set high, so that degradation of the battery 400 may be reduced by the regenerative braking.

According to some embodiments, the at least one processor 320 may be configured to maintain the same regenerative braking level in response to a change in battery data and to adjust a driving strategy in consideration of a difference in battery charging amount due to the maintenance of the regenerative braking level. For example, even if battery data fluctuates as in a SOC level fluctuation 910, the regenerative braking level may be maintained and only the driving strategy may be controlled. According to this method, it is possible to prevent a change in the regenerative braking level from affecting the lifespan of the battery 400.

According to some embodiments, the at least one processor 320 may be configured to determine whether an increase in the regenerative braking level is required in the next period based on a change in battery data in a current period, determine the regenerative braking level in the next period as in the current period in the case where it is determined that the increase is required, and adjust the driving strategy in the next period by reflecting a decrease amount in battery charging amount due to the maintenance of the regenerative braking level.

According to some embodiments, the current period and the next period may have values such as 1 second, 3 seconds, 5 seconds, 10 seconds, 15 seconds, 20 seconds, 30 seconds, 1 minute, 2 minutes, 3 minutes, 5 minutes, 10 minutes, and the like. According to battery data that varies in the current period, an increase in the regenerative braking level may or may not be required. For example, when the output voltage, output current, and SOC level of the battery 400 decrease in the current period, it may be determined that the regenerative braking level needs to be increased. Although the regenerative braking level needs to be increased, the regenerative braking level in the next period may be the same as the regenerative braking level in the current period. Since the regenerative braking level is not increased, the battery charging amount may decrease, and the driving strategy in the next period may be adjusted to compensate for the decrease amount in the battery charging amount. For example, in order to compensate for the decrease amount in battery charging amount, driving responsiveness may be lowered, an inter-vehicle distance may be set to be increased, and a driving route may be changed to a route having a high auto cruise speed rate. In this way, since an increase in the regenerative braking level may be prevented, degradation of the battery 400 by regenerative braking may be reduced.

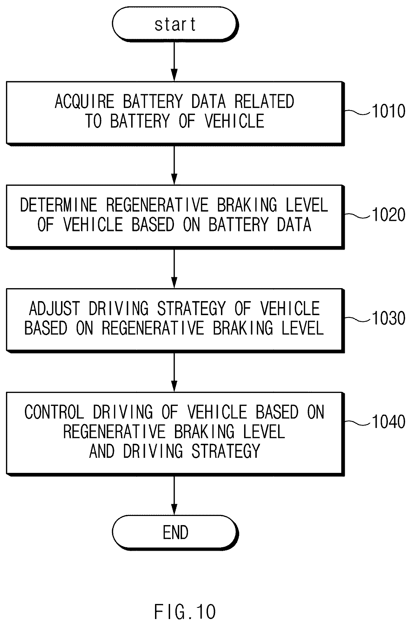

FIG. 10 is a diagram illustrating operations constituting a method for operating a computing system according to some embodiments disclosed herein.

Referring to FIG. 10, a method 1000 for operating a computing system 300 may include operations 1010 to 1040. However, the method is not limited thereto, and some operations may be omitted or general-purpose operations may be added, and the operations of the operation method 1000 may be executed in a different order from the illustrated order.

Operations 1010 to 1040 of the operating method 1000 of the computing system 300 may be performed by the computing system 300 of the vehicle 10. According to some embodiments, the operation method 1000 may include operations processed time-sequentially by the computing system 300. Therefore, the description for the computing system 300 above may be equally applied to the operating method 1000 even if the description is omitted below.

In operation 1010, the computing system 300 may acquire battery data related to the battery of the vehicle.

In operation 1020, the computing system 300 may determine a regenerative braking level of the vehicle based on the battery data.

In operation 1030, the computing system 300 may adjust the driving strategy of the vehicle based on the regenerative braking level.

**In** operation 1040, the computing system 300 may control driving of the vehicle based on the regenerative braking level and the driving strategy.

According to some embodiments, the operating method 1000 of the computing system 300 may be implemented in the form of a computer program stored in a computer-readable storage medium. That is, the computer program may include instructions for implementing the operating method 1000, and the instructions of the program may be stored in a computer-readable storage medium. A computer program may include a mobile application.

For example, the computer-readable media may include magnetic media such as hard disks, floppy disks, and magnetic tape; optical media such as CD-ROMs and DVDs; magneto-optical media such as floptical disks; and hardware devices that are specially configured to store and perform program instructions, such as ROM, RAM, flash memory, and the like. Program instructions may include machine codes produced by a compiler, and higher level codes that may be executed by the computer using an interpreter.

The terms such as "comprises," "includes" or "have" described above mean that the corresponding element may be embedded unless otherwise stated, so it means that other elements may be further included but not excluded. Unless defined otherwise, all terms used herein, including technical or scientific terms, have the same meanings as those generally understood by those skilled in the art to which the present disclosure pertains.

Although exemplary embodiments of the present disclosure have been described for illustrative purposes, those skilled in the art will appreciate that various changes and modifications are possible, without departing from the scope and spirit of the disclosure. Therefore, the embodiments disclosed in the present disclosure are provided for the sake of descriptions, not limiting the technical concepts of the present disclosure, and it should be understood that such embodiments are not intended to limit the scope of the technical concepts of the present disclosure. The protection scope of the present disclosure should be understood by the claims below, and all the technical concepts within the equivalent scopes should be interpreted to be within the scope of the right of the present disclosure.

### [Explanation of Reference Numerals]

| | | | |
|---|---|---|---|
| 1: | vehicle management system | 10: | vehicle |
| 20: | network | 30: | autonomous driving management server |
| 40: | energy management server | 100: | communication module |
| 200: | sensor module | 300: | computing system |
| 310: | interface circuit | 320: | at least one processor |
| 400: | battery | 410: | battery pack |
| 420: | battery management system | 500: | driving system |

## Claims

1. A computing system, comprising:
at least one processor configured to:
receive battery data related to a battery of a vehicle;
determine a regenerative braking level of the vehicle based on the battery data;
adjust a driving strategy of the vehicle based on the regenerative braking level; and
control driving of the vehicle based on the driving strategy.

2. The computing system of claim 1, wherein the battery data includes a state of charge (SOC) level of the battery and the at least one processor is further configured to:
determine the regenerative braking level based on a relationship inversely proportional to the SOC level.

3. The computing system of claim 2, wherein the at least one processor is further configured to:
calculate a discharging amount of the SOC level based on driving of the vehicle and a charging amount of the SOC level based on regenerative braking of the vehicle,
wherein the regenerative braking level is determined based on the discharging amount and the charging amount.

4. The computing system of claim 3, wherein the at least one processor is further configured to:
calculate a predicted discharging amount and a predicted charging amount of the SOC level after a predetermined time has elapsed, wherein calculating the predicted discharging amount and the predicted charging amount is based on the discharging amount and the charging amount; and
determine a next level of the regenerative braking level based on the predicted discharging amount and the predicted charging amount.

5. The computing system of claim 1, wherein adjusting the driving strategy of the vehicle based on the regenerative braking level includes adjusting one or more of a driving speed, driving route, driving responsiveness, or headway distance setting of the vehicle.

6. The computing system of claim 5, wherein adjusting the driving strategy of the vehicle based on the regenerative braking level includes increasing the driving speed of the vehicle and/or decreasing the headway distance setting when the regenerative braking level increases.

7. The computing system of claim 5, wherein adjusting the driving strategy of the vehicle based on the regenerative braking level includes increasing the driving responsiveness and/or setting the driving route to a route requiring more braking by the vehicle when the regenerative braking level increases.

8. The computing system of claim 5, wherein adjusting the driving strategy of the vehicle based on the regenerative braking level includes decreasing the driving speed of the vehicle and/or increasing the headway distance setting when the regenerative braking level decreases.

9. The computing system of claim 5, wherein adjusting the driving strategy of the vehicle based on the regenerative braking level includes decreasing the driving responsiveness to reduce acceleration and/or braking events and/or setting the driving route to a route requiring less braking by the vehicle when the regenerative braking level decreases.

10. The computing system of claim 1, wherein the at least one processor is further configured to:
maintain the same regenerative braking level in response to a change in the battery data; and
adjust the driving strategy based on a difference in battery charging amount due to the maintenance of the regenerative braking level.

11. The computing system of claim 10, wherein the at least one processor is further configured to:
determine whether an increase in the regenerative braking level is required in a next period based on a change in the battery data in a current period;
determine the regenerative braking level in the next period in the same manner as in the current period where it is determined that the increase is necessary; and
adjust the driving strategy in the next period by reflecting a decrease amount in the battery charging amount due to the maintenance of the regenerative braking level.

12. A vehicle comprising:
a battery; and
the computing system of claim 1.

13. A method of controlling a vehicle, comprising:
receiving, by one or more processors, battery data related to a battery of the vehicle;
determining, by the one or more processors, a regenerative braking level of the vehicle based on the battery data;
adjusting, by the one or more processors, a driving strategy of the vehicle based on the regenerative braking level; and
controlling, by the one or more processors, driving of the vehicle based on the driving strategy.

14. The method of claim 13, wherein the battery data includes a state of charge (SOC) level of the battery, and
wherein determining the regenerative braking level comprises determining the regenerative braking level based on a relationship inversely proportional to the SOC level.

15. The method of claim 14, wherein determining the regenerative braking level comprises:
calculating a discharging amount of the SOC level based on driving of the vehicle and a charging amount of the SOC level based on regenerative braking of the vehicle, wherein the regenerative braking level is determined based on the discharging amount and the charging amount.

16. The method of claim 13, wherein determining the regenerative braking level includes maintaining the same regenerative braking level in response to a change in the battery data, and
wherein adjusting the driving strategy comprises adjusting the driving strategy in consideration of a difference in battery charging amount due to the maintenance of the regenerative braking level.

17. The method of claim 13, wherein adjusting the driving strategy of the vehicle based on the regenerative braking level includes adjusting one or more of a driving speed, driving route, driving responsiveness, or headway distance setting of the vehicle.

18. The method of claim 17, wherein adjusting the driving strategy of the vehicle based on the regenerative braking level includes, when the regenerative braking level increases, increasing the driving speed of the vehicle, decreasing the headway distance setting, increasing the driving responsiveness, and/or setting the driving route to a route requiring more braking by the vehicle.

19. The method of claim 17, wherein adjusting the driving strategy of the vehicle based on the regenerative braking level includes, when the regenerative braking level decreases, decreasing the driving speed of the vehicle, increasing the headway distance setting, decreasing the driving responsiveness to reduce acceleration and/or braking events, and/or setting the driving route to a route requiring less braking by the vehicle.

20. A non-transitory computer readable medium storing instructions, which, when executed by at least one processor, causes the at least one processor to perform operations of:
acquiring battery data related to a battery of a vehicle;
determining a regenerative braking level of the vehicle based on the battery data;
adjusting a driving strategy of the vehicle based on the regenerative braking level; and
controlling driving of the vehicle based on the driving strategy.
